# EUROPEAN PATENT SPECIFICATION

(11) **EP 0 169 908 B1**
(45) Date of publication and mention of the grant of the patent: **01.12.1993**
(21) Application number: 85900742.9
(22) Date of filing: 18.01.1985
(51) Int. Cl.: G06F 11/10, H03M 13/00, G11B 20/18

(54) **METHOD AND CIRCUIT FOR DECODING ERROR CODED DATA**
VERFAHREN UND SCHALTUNG ZUR DEKODIERUNG VON FEHLERCODE-DATEN
Procédé et circuit de décodage de données de code d'erreurs

(30) Priority: 21.01.1984 JP 9150/84; 31.01.1984 JP 15704/84
(43) Date of publication of application: 05.02.1986
(73) Proprietor: SONY CORPORATION, Tokyo 141 (JP)
(72) Inventor: HORI, Katsuya Sony Corporation, Shinagawa-ku Tokyo 141 (JP); FURUYA, Tsuneo Sony Corporation, Shinagawa-ku Tokyo 141 (JP)
(74) Representative: TER MEER STEINMEISTER & PARTNER GbR
(86) International application number: PCT/JP85/00017
(87) International publication number: WO 85/03371

(56) References cited:
- EP-A- 0 061 345
- EP-A- 0 096 165
- JP-A- 5 432 240
- US-A- 4 037 093
- 3RD INTERNATIONAL CONFERENCE, THE TECHNOLOGY AND APPLICATIONS OF CHARGE COUPLED DEVICES, Edinburgh, September 1976, pages D1-D13; T.F. ROOME et al.: "Finite field arithmetic with charge transfer devices"
- W.W. Peterson, E.J. Weldon, Jr. "ERROR-CORRECTING CODES, Second Edition" (1972) The MIT Press (Cambridge, Massachusetts), p. 180

## Description

The present invention relates to a method and a circuit for operating finite fields used for decoding of data being coded with an error correction code.

When a digital video signal, a digital audio signal or the like is recorded or reproduced, adjacent codes, Reed Solomon codes or the like have been put to practical use as error correction codes. In the encoder of these error correction codes, parity data (redundant data) is generated. In the decoder, a syndrome is generated from the received word including parity data and the error correction is performed using this syndrome. A circuit for operating finite fields is used as a hardware of parity generating circuits, syndrome generating circuits and error correcting circuits. The finite field is the field having p^{m} elements derived from the primitive polynomial P(x) of degree m. The case of (p = 2) is important with respect to the error correction codes and this invention, accordingly, is applied to the finite field of (p = 2).

Principally there are two different methods to multiply or divide elements of a finite field. A first method is to use shift registers, adders, and/or a plurality of, multipliers. This methods allows to use circuits of small scale and/or it makes it possible to perform the calculations by a general microprocessor. The other method is to use a ROM which is addressed by the elements to be multiplied or divided and which stores exponents for these elements. This method works very fast, however, needs a rather large circuit scale because of the ROM.

Most of the methods and devices are arranged to operate the elements of a finite field based on p = 2. However, it is also known to operate the elements of finite fields based on other primes. E. g. an article published by T.F. Roome et al in 3rd International Conference on charge coupled devices, Edinburgh, September 1976, pages D1 - D13 with the title "The Technology and Applications of Charge Coupled Devices" describes operation of elements in a finite field with p = 7. CCD-registers act as shift registers accommodating p distinct levels.

It is the object of the present invention to provide a method and a circuit for decoding error coded data by operating finite fields for p = 2 having high processing speed but requiring low memory quantity and a small circuit scale.

The method of the present invention for decoding error coded data by operating a multiplication or a division in relation to arbitrary elements αⁱ (i = integer) and α over a finite field of 2^{m} (m = positive integer), where α is a root of a primitive polynomial of the finite field and the said elements are the bits of said error coded data, comprises the steps of:
- providing first digital data of at least m + 1 bits corresponding to a vector representation of the primitive polynomial;
- providing second digital data of m bits corresponding to a vector representation of the arbitrary element i;
- shifting the second digital data by one bit to the most significant bit side in a case of the multiplication;
- discriminating the m-th significant bit of the second digital data in the case of the multiplication or the least significant bit of the second digital data in a case of the division;
- outputting the shifted second digital data when the m-th significant bit of the second digital data is "0" in the case of the multiplication;
- modulo-2-adding the first digital data and the shifted second digital data when the m-th significant bit of the second digital data is not "0" so as to produce an added data and outputting the added data in the case of the multiplication;
- shifting the second digital data by one bit to the least significant bit side when the least significant bit of the second digital data is "0" and outputting the shifted second digital data in the case of the division;
- modulo-2-adding the first digital data and the second digital data when the least significant bit of the second digital data is not "0" so as to produce an added data in the case of the division; and
- shifting the added data by one bit to the least significant bit side and outputting the added data in the case of the division.

The circuit of the present invention for decoding error coded data by operating a multiplication or a division in relation to arbitrary elements αⁱ (i = integer) and α over a finite field of 2^{m} (m = positive integer), where α is a root of a primitive polynomial of the finite field and the said elements are the bits of said error coded data, comprises:
- an accumulator (10) for storing second digital data of m bits corresponding to a vector representation of the arbitrary element αⁱ;
- an adder (11) for performing a modulo-2-addition using the contents of said accumulator (10) and first digital data of at least m + 1 bits corresponding to a vector representation of the primitive polynomial as operands; and
- a control section (3) for controlling the bit-shift in said accumulator (10) and the operation of said adder (11) in a manner of
   -- providing said accumulator (10) with the second digital data of m bits;
   -- shifting the second digital data in said accumulator (10) by one bit to the most significant bit side in a case of the multiplication;
   -- discriminating the m-th significant bit of the second digital data in the case of the multiplication or the least significant bit of the second digital data in a case of the division;
   -- outputting the shifted second digital data from said accumulator (10) when the m-th significant bit is "0" in the case of the multiplication;
   -- providing said adder (11) with the first digital data when the m-th significant bit of the second digital data is not "0";
   -- modulo-2-adding the first digital data and the shifted second digital data from said accumulator (10) when the m-th significant bit of the second digital data is not "0" so as to produce an added data and outputting the added data from said adder (11) in the case of the multiplication;
   -- shifting the second digital data in said accumulator (10) by one bit to the least significant bit side when the least significant bit of the second data is "0" and outputting the shifted second digital data from said accumulator (10) in the case of the division;
   -- providing said adder (11) with the first digital data; when the least significant bit of the second digital data is not "0";
   -- modulo-2-adding the first digital data and the second digital data from said accumulator (10) when the least significant bit of the second data is not "0" so as to produce an added data in the case of the division;
   -- storing the added data from said adder (11) in said accumulator (10); and
   -- shifting the added data in said accumulator (10) by one bit to the least significant bit side and outputting the added data from said accumulator (10) in the case of the division.

The book "Error-Correcting Codes", The MIT Press (Cambridge, USA and London, GB), pp. 178 - 180, by W.W.Peterson and E.J.Weldon Jr. shows different circuits for counting forward and backward in a Galois field of 2^{m} whereby counting forward from an arbitrary element αⁱ corresponds to successive multiplications with α, where α is a root of the primitive polynomial of the finite field and counting backward corresponds to successive divisions by α.
It is shown that i.e. in case of the multiplication a one shifted out of the high order position corresponds to α^{m} which is replaced by its equivalent according to the characteristic polynomial and added to the register by means of EXOR - feedback connections.
The addition is always carried out over m bits after the shift.

It is a very essential feature of the method and the circuit of the present invention that it is checked for the m-th significant bit of the second digital data whether it is "0" or "1". Depending on the checked value, different processings are performed. These processings operate very fast by using low memory capacity of the used shifting means.

Further objects, advantages and features of the present invention will become more clear from the following description of drawings.
Fig. 1 is a block diagram of an embodiment of the present invention;
Figs. 2 and 3 are a flowchart and a schematic diagram, respectively, which are used to explain the multiplying operation in the embodiment;
Figs. 4 and 5 are a flowchart and a schematic diagram, respectively, which are used to explain the dividing operation in the embodiment;
Fig. 6 is a block diagram of a circuit for reproducing a digital audio disc to which the present invention can be applied;
Fig. 7 is a schematic diagram which is used to explain the reproduced data of the digital audio disc; and
Figs. 8 and 9 are a time chart and a block diagram which are used to explain an error correcting circuit.

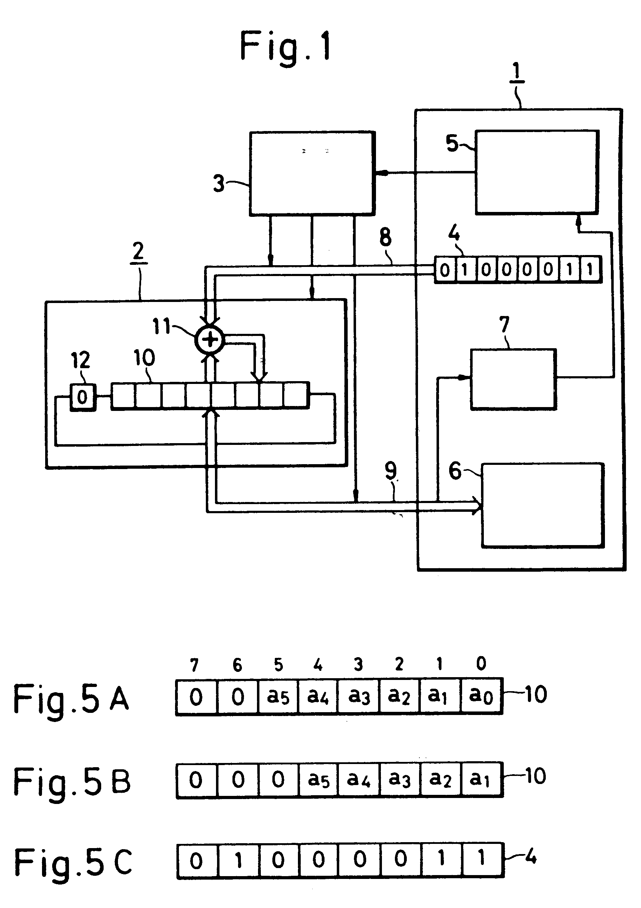

One embodiment of the present invention will now be described with reference to Fig. 1. In Fig. 1, a reference numeral 1 denotes a memory section, 2 indicates an accumulator and an arithmetic operating section, and 3 is a control section. In this embodiment, $\text{(P(x) = x⁶ + x + 1)}$ over the GF (2⁶) is used as a primitive polynomial.

In this case, each element is expressed by

$\text{a₅X⁵ + a₄X⁴ + a₃X³ + a₂X² + a₁X + a₀}$

By multiplying X to this element, we have

$\text{a₅X⁶ + a₄X⁵ + a₃X⁴ + a₂X³ + a₁X² + a₀X}$

When (a₅ = 0),

$\text{a₄X⁵ + a₃X⁴ + a₂X³ + a₁X² + a₀X}$

and when (a₅ = 1),

$\text{X⁶ = X + 1}$

Therefore, we have

$\text{a₄X⁵ + a₃X⁴ + a₂X³ + a₁X² + (a₀ + 1) X + 1}$

According to the vector expression, when (a₅ = 0),
(a₄, a₃, a₂, a₁, a₀, 0)
and when (a₅ = 1),
(a₄, a₃, a₂, a₁, a₀ + 1, 1)
(01000011) of which "0" was further added to the higher significant bits of the primitive polynomial P(x) represented by a vector is stored in a register 4 in the memory section 1. A program ROM 5, a RAM 6 and a discriminating circuit 7 are provided in the memory section 1. An address from this address generating section (not shown) which is supplied with a discrimination output of the discriminating circuit 7 is supplied to the program ROM 5, so that instructions from the program ROM 5 are generated in accordance with a predetermined sequence. These instructions are supplied to the control section 3, so that control signals to respectively control paths 8 and 9 and the accumulator and arithmetic operating section 2 are generated from the control section 3.

The accumulator and arithmetic operating section 2 has an accumulator 10 and an adder 11 for performing the addition of (mod. 2) in relation to the contents of the accumulator 10 and the contents of the register 4 derived through the path 8 and then supplying the addition output to the accumulator 10. The accumulator 10 performs the operation to shift to the left by one bit or to shift to the right by one bit in response to the control signal from the control section 3. Upon this shifting operation, the bit in the edge portion is set to "0" by an output of a register 12. The data from the RAM 6 is set into the accumulator 10 through the path 9 and also the arithmetic operation output is supplied to the RAM 6 through the path 9.

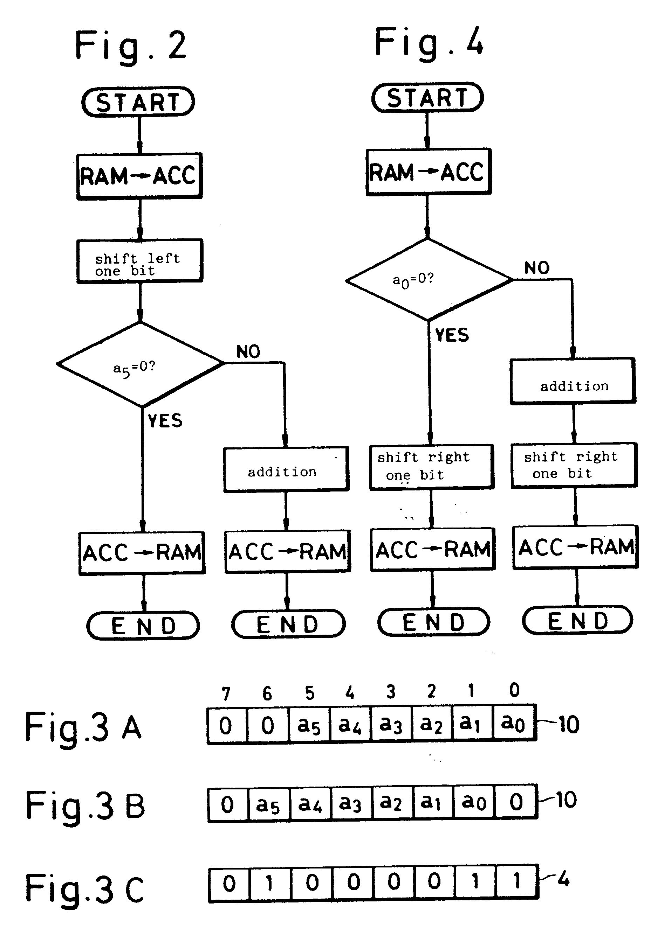

The operation when the multiplication between arbitrary elements αⁱ and α over the GF (2⁶) is performed in the foregoing embodiment of the present invention will be described with reference to Figs. 2 and 3.

First, six bits for representing αⁱ by a vector are read out from the RAM 6 and are stored into the accumulator 10 through the path 9. Assuming that eight bits in the accumulator 10 are bits 0 to 7, six bits (a₅, a₄, a₃, a₂, a₁, a₀) representing αⁱ by a vector are stored into bits 0 to 5 as shown in Fig. 3A.

In next step, the bits in the accumulator 10 are shifted to the left by one bit. Fig. 3B shows the state in that those bits were shifted to the left by one bit. A check is made by the discriminating circuit 7 to see if the bit 6 in the accumulator 10, namely, a₅ is "0" or not. When (a₅ = 0), six bits (a₄, a₃, a₂, a₁, a₀, 0) of the bits 0 to 5 in the accumulator 10 are set to the multiplication output of (αⁱ x α) and are outputted from the accumulator 10 through the path 9 to the RAM 6.

When (a₅ = 1), the contents of the accumulator 10 (Fig. 3B) and the contents of the register 4 (Fig. 3C) in the memory section 1 are added by the adder 11 of (mod. 2). Six bits of the bits 0 to 5 of this addition output become (a₄, a₃, a₂, a₁, a₀ + 1, 1) and this addition output is set to the multiplication output of (αⁱ x α) and is outputted from the accumulator 10 through the path 9 to the RAM 6.

When the root of the primitive polynomial $\text{(P(x) = x⁶ + x + 1)}$ is α, the vector expression becomes practically as shown below, wherein (α⁰ to α¹²) are shown for simplicity.
α⁰ = (000001)
α¹ = (000010)
α² = (000100)
α³ = (001000)
α⁴ = (010000)
α⁵ = (100000)
α⁶ = (000011)
α⁷ = (000110)
α⁸ = (001100)
α⁹ = (011001)
α¹⁰ = (110001)
α¹¹ = (100011)
α¹² = (000101)
When this invention is applied to the multiplication of $\text{(α¹¹ x α)}$ as an example, the adding operation is performed since (a₅ = 1), so that the multiplication output of (000101), namely, α¹² can be obtained.

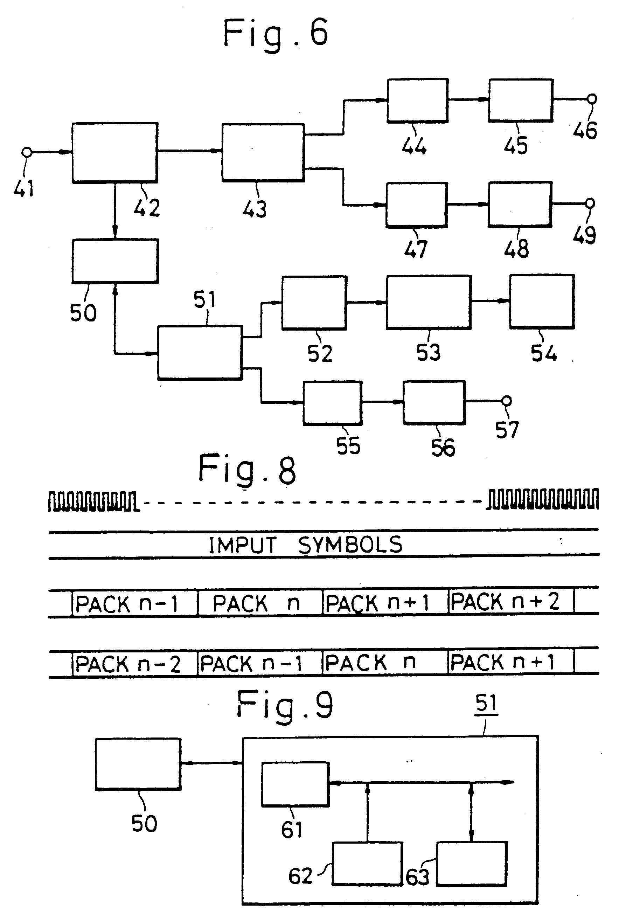

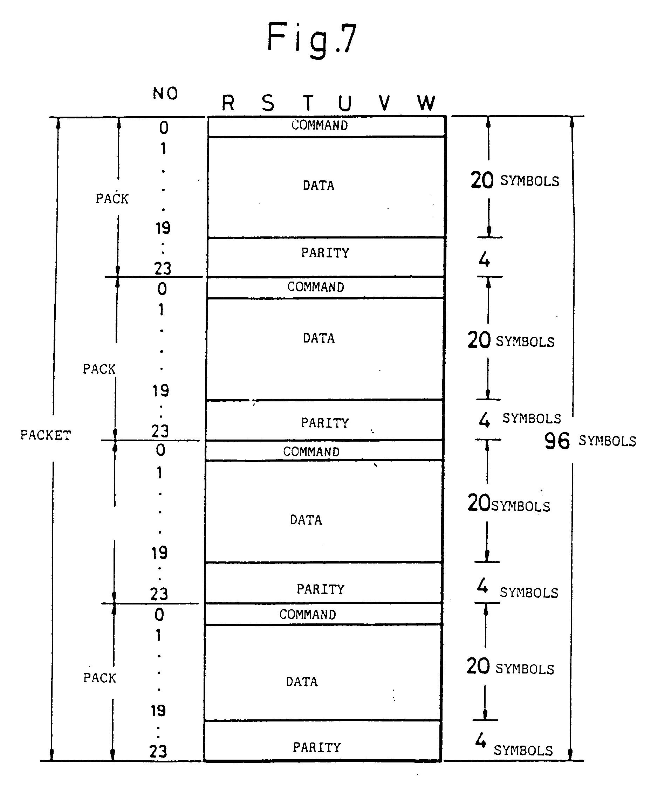

On the other hand, in this embodiment, the division of ${\text{(α}}^{\text{i}} \text{÷ α)}$ can be performed. Fig. 4 shows a flowchart for the dividing operation. First, six bits (a₅ to a₀) representing αⁱ by a vector from the RAM 6 through the path 9 are stored into the bits 0 to 5 in the accumulator 10 as shown in Fig. 5A. Next, a check is made by the discriminating circuit 7 to see if the bit 0, namely, a₀ is "0" or not. When (a₀ = 0), the bits in the accumulator 10 are shifted to the right by one bit and they become as shown in Fig. 5B. Then, the bits 0 to 5 in the accumulator 10 are supplied as the division output to the RAM 6 through the path 9 and are stored in the RAM 6.

When (a₀ = 1), the contents shown in Fig. 5A of the accumulator 10 and the contents shown in Fig. 5C of the register 4 obtained through the path 8 are added by the adder 11 in (mod. 2). This addition output is shifted to the right by one bit and the bits 0 to 5 in the accumulator 10 are supplied as the division output through the path 9 to the RAM 6 and are stored into the RAM 6.

As a practical example, in case of performing the division of $\text{(α⁶ ÷ α)}$ , (α⁶ = 000011) is stored into the accumulator 10 and the adding operation is executed since (a₀ = 1). The contents of the accumulator 10 into which the addition output was stored becomes (01000000) and the contents (100000 = α⁵) of the bits 0 to 5 after the shifting operation to the right by one bit becomes the division output.

Further, the multiplication of ${\text{(α}}^{\text{i}} {\text{x α}}^{\text{n}} \text{)}$ or division of ${\text{(α}}^{\text{i}} {\text{÷ α}}^{\text{n}} \text{)}$ may be executed by repeating the foregoing arithmetic operation steps n times.

The above-mentioned circuit for operating finite fields is used for a decoder of error correction codes, for example, Reed Solomon codes. These error correction codes are used with regard to the subcoding signal which is included in the reproduced signal of a digital audio disc.

Fig. 6 shows an arrangement of a reproducing circuit of an optical type digital audio disc (what is called a compact disc). The reproduced signal read out from the disc by an optical head is supplied through an input terminal indicated at a reference numeral 41 to an EFM demodulating circuit 42. The digial signal recorded on the disc has been EFM-modulated. The EFM-modulation is a method for block-converting the 8-bit data into a preferable pattern of 14 bits (namely, 14 bits such that the minimum transition time of the modulated signal becomes longer and the low-frequency component becomes less).

The digital audio signal which was returned to the 8-bit data by the EFM demodulator 42 is supplied to an error correcting circuit 43 and the error correction is performed. The digital audio signal in one channel of the stereophonic audio signals which are outputted from the error correction circuit 43 is supplied to a D/A converter 44 and is converted into the analog signal. This analog signal is derived at an output terminal 46 through a low-pass filter 45. The digital audio signal in the other channel which is outputted from the error correction circuit 43 is supplied to a D/A converter 47 and is converted into the analog signal. This analog signal is derived at an output terminal 49 through a low-pass filter 48.

In addition to the stereophonic audio signals, a digital signal for control or display which is called a subcoding signal is included in the reproduced signal from a disc. The subcoding signal of every 8 bits is included in every frame of the recorded data. The subcoding signal is repeated at a period of 98 frames. So that synchronous signal for the subcoding signal is inserted into the first two frames for every 98 frames. Eight bits of the subcoding signal are classified into (P, Q, R, S, T, U, V, W). The P-channel is used to distinguish the recording interval and pause interval of the music signal recorded on a disc. The Q-channel is constituted by: music numbers added to the respective music signals on a disc; indices to further divide each music program; time codes which increase for the intervals of music programs and decrease for the pause intervals; time codes which sequentially change from the beginning of the program region on a disc; control bits to indicate the presence/absence or the like of a pre-emphasis; etc. With regard to the Q-channel, the CRC codes for error detection are assigned into the 16 frames on the side of the final end among the 98 frames. It is possible to search the beginning of the designated music programs or the like using the subcoding signals in the P- and Q-channels.

The R- to W-channels are used to display the songwriter, composers, descriptions, text, etc. of music programs recorded on a disc or to explain them by a voice. One packet is constituted by the data in 96 frames excluded the sync pattern, P-channel and Q-channel from the subcoding signals of (8 bits x 98 frames). As shown in Fig. 7, the packet of (6 x 96) bits is further divided into four packs each consisting of 24 symbols. The first symbol in each pack is a command and the next 19 symbols are data and the remaining four symbols are a parity of the error correction code of each pack. This command has six bits consisting of a mode of three bits and an item of three bits. The kind of data (graphic data, still image data, sound data, etc.) is indicated by three bits of the mode. The information of the detailed operating mode of each mode is represented by three bits of the item.

The foregoing subcoding signals are separated by the EFM demodulator 42 and are stored into a buffer memory 50. The subcoding signals in the R- to W-channels are subjected to the error correction by an error correcting circuit 51. Although not shown, the data in the P- and Q-channels in the subcoding signals are supplied to a system controller. The subcoding signals in the R- to W-channels which are outputted from the error correcting circuit 51 are written into a buffer memory 52 in case of the graphic data or still image data. The data read out from the buffer memory 52 is supplied to a display control circuit 53 and is displayed on a display apparatus 54 such as a CRT display or the like. In the case where the subcoding signals in the R- to W-channels are the sound data, they are derived at an output terminal 57 through a D/A converter 55 and a low-pass filter 56.

Fig. 8A shows a symbol clock (7.35 kHz) of the subcoding signal in the reproduced data. Fig. 8B shows input symbols. As shown in Fig. 8C, the error correction is performed for every one pack in the error correcting circuit 51. The packs which have already been decoded during this error correcting operation are outputted as shown in Fig. 8D.

As shown in Fig. 9, the error correcting circuit 51 has a CPU 61, a ROM 62 in which a program has been written, and a RAM 63 for a work area. In the error correction circuit 51, the inputting operation to write 24 symbols of one pack from the buffer memory 50 into the RAM 63, the error correcting operation to perform the arithmetic operation of the syndromes, calculation of the error locations and error corrections by use of the data read out from the RAM 63, and the outputting operation to output the data after the error correction from the RAM 63 are carried out under control of the CPU 61.

As error correction codes with respect to the pack of (6 x 24) bits, the (24, 20) Reed Solomon codes are used. The primitive polynomial of these Reed Solomon codes is $\text{(P(x) = x⁶ + x + 1)}$ over the GF (2⁶). 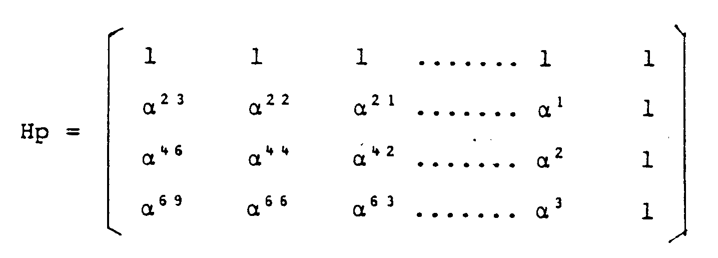
is used as a parity check matrix Hp. The syndromes are calculated from the matrix expression Vp of the subcoding signals in one pack and the parity check matrix Hp. When reproduced one symbol is expressed as Wᵢ, the syndromes S₀, S₁, S₂, and S₃ become 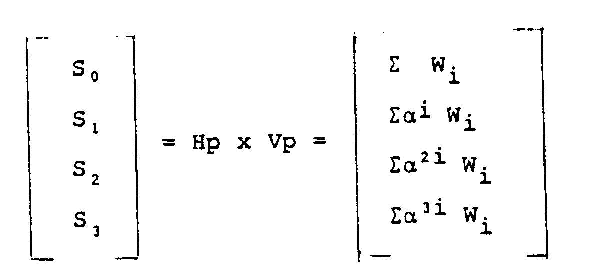
Where, Σ denotes 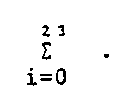
The sizes of errors are checked by way of the syndromes derived from the above equation.

In case of no error, S₀ = 0 and S₃ = 0 and A = B = C = 0.

In case of one symbol error, S₀ ≠ 0 and S₃ ≠ 0, and A = B = C = 0.

In case of two symbols error, A ≠ 0 and B ≠ 0 and C ≠ 0, where ( $\text{A = S₀ S₁ + S₁²}$ , $\text{B = S₁ S₂ + S₀ S₃}$ 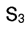 , $\text{C = S₁ S₃ + S₂²}$ ).

The error locations are obtained with regard to the foregoing one-symbol error and two-symbols error, respectively.

When one-symbol error is detected (it is assumed that the error location is i),

${\text{α}}^{\text{i}} \text{= S₁ /S₀}$
${\text{e}}_{\text{i}} \text{= S₀}$

so that i = log(S₁/S₀).

When two-symbols error is detected (it is assumed that the error locations are i and j),

${\text{α}}^{\text{i}} \text{= D/X}$
${\text{α}}^{\text{j}} \text{= (D/Y)}$
${\text{e}}_{\text{i}} \text{= S₀/Y + S₁/D}$
${\text{e}}_{\text{j}} \text{= S₀/X + S₁/D}$

where, $\text{D = B/A}$ . X is obtained by setting $\text{E = C/A}$ and $\text{(D²/E → X)}$ (where, ${\text{D²/E = α}}^{\text{-a}} {\text{+ α}}^{\text{a}}$ , ${\text{X = 1 + α}}^{\text{a}} \text{: a = j - i = 1 to 23}$ 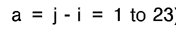 ). Y is derived by setting $\text{Y = D²/E + X}$ .

For correction of both of the one-symbol error and two-symbols error, the addition of (mod. 2) may be performed with regard to the reproduced erroneous symbols and the error patterns obtained.

The circuit for operating finite fields according to the present invention is applied upon the foregoing error correcting operations. In particular, a multiplication and a division in relation to elements over the GF (2⁶)represented by a vector are executed when the error states are checked or when the error patterns are calculated; therefore, it is suitable to apply this invention to such cases. The data transmitting rate of the subcoding signal on a digital disc is lower than that of the data in the main channel and the error correcting circuit 51 of the subcoding signal can be constituted using a general microcomputer by applying this invention.

According to the present invention, the multiplication of ${\text{(α}}^{\text{i}} \text{x α)}$ and division of ${\text{(α}}^{\text{i}} \text{÷ α)}$ over a finite field can be performed as elements over the finite field are represented by a vector without using any ROM and without needing a discrimination of an exponent in (mod. 2^{m} - 1). Therefore, the scale of the hardware can be made small and the number of steps for arithmetic operation can be remarkably reduced. By applying this invention to a decoder of the Reed Solomon codes, the hardware of the decoder can be simplified and also the decoding time can be reduced.

In addition, according to the present invention, since a multiplication or a division of arbitrary two elements can be performed as elements over a finite field are represented by a vector, a general microcomputer can be used as a hardware. Consequently, the hardware can be cheaply realized.

## Claims

1. A method for decoding error correction coded data by operating a multiplication or a division in relation to arbitrary elements αⁱ, i being an integer, and α over a finite field of 2^{m}, m being a positive integer, where α is a root of a primitive polynomial of the finite field, and the said elements are the bits of said error correction coded data, the method comprising the steps of:
- providing first digital data of at least m + 1 bits corresponding to a vector representation of the primitive polynomial;
- providing second digital data of m bits corresponding to a vector representation of the arbitrary element αⁱ;
- shifting the second digital data by one bit to the most significant bit side in a case of the multiplication;
- discriminating the m-th significant bit of the second digital data in the case of the multiplication or the least significant bit of the second digital data in a case of the division;
- outputting the shifted second digital data when the m-th significant bit of the second digital data is "0" in the case of the multiplication;
- modulo-2-adding the first digital data and the shifted second digital data when the m-th significant bit of the second digital data is not "0" so as to produce an added data and outputting the added data in the case of the multiplication;
- shifting the second digital data by one bit to the least significant bit side when the least significant bit of the second digital data is "0" and outputting the shifted second digital data in the case of the division;
- modulo-2-adding the first digital data and the second digital data when the least significant bit of the second digital data is not "0" so as to produce an added data in the case of the division; and
- shifting the added data by one bit to the least significant bit side and outputting the added data in the case of the division.

2. A method according to claim 1, **characterized in that** said steps are repeated j times for multiplication or division in relation to two elements αⁱ and α^{j} instead of αⁱ and α.

3. A circuit for decoding error correction coded data by operating a multiplication or a division in relation to arbitrary elements αⁱ, i being an integer, and α over a finite field of 2^{m}, m being a positive integer, where α is a root of a primitive polynomial of the finite field, and the said elements are the bits of said error correction coded data, said circuit comprising:
- an accumulator (10) for storing second digital data of m bits corresponding to a vector representation of the arbitrary element αⁱ;
- an adder (11) for performing a modulo-2-addition using the contents of said accumulator (10) and first digital data of at least m + 1 bits corresponding to a vector representation of the primitive polynomial as operands; and
- a control section (3) for controlling the bit-shift in said accumulator (10) and the operation of said adder (11) in a manner of
-- providing said accumulator (10) with the second digital data of m bits;
-- shifting the second digital data in said accumulator (10) by one bit to the most significant bit side in a case of the multiplication;
-- discriminating the m-th significant bit of the second digital data in the case of the multiplication or the least significant bit of the second digital data in a case of the division;
-- outputting the shifted second digital data from said accumulator (10) when the m-th significant bit is "0" in the case of the multiplication;
-- providing said adder (11) with the first digital data when the m-th significant bit of the second digital data is not "0";
-- modulo-2-adding the first digital data and the shifted second digital data from said accumulator (10) when the m-th significant bit of the second digital data is not "0" so as to produce an added data and outputting the added data from said adder (11) in the case of the multiplication;
-- shifting the second digital data in said accumulator (10) by one bit to the least significant bit side when the least significant bit of the second data is "0" and outputting the shifted second digital data from said accumulator (10) in the case of the division;
-- providing said adder (11) with the first digital data; when the least significant bit of the second digital data is not "0";
-- modulo-2-adding the first digital data and the second digital data from said accumulator (10) when the least significant bit of the second data is not "0" so as to produce an added data in the case of the division;
-- storing the added data from said adder (11) in said accumulator (10); and
-- shifting the added data in said accumulator (10) by one bit to the least significant bit side and outputting the added data from said accumulator (10) in the case of the division.

## Patentansprüche

1. Verfahren zum Dekodieren Fehlerkorrektur-kodierter Daten durch eine Multiplikation oder eine Division in Relation zu beliebigen Elementen αⁱ, wobei i eine ganze Zahl ist, und α über ein finites Feld mit 2^{m}, wobei m eine positive ganze Zahl und α eine Wurzel eines primitiven Polynoms des finiten Feldes ist und die Elemente die Bits der Fehlerkorrektur-kodierten Daten sind, welches Verfahren folgende Schritte aufweist:
- Bereitstellen erster digitaler Daten mit mindestens m + 1 Bits entsprechend einer Vektorrepräsentation des primitiven Polynoms;
- Bereitstellen zweiter digitaler Daten mit m Bits entsprechend einer Vektorrepräsentation des willkürlichen Elementes αⁱ;
- Verschieben der zweiten digitalen Daten um ein Bit zur Seite des höchstsignifikanten Bits im Fall der Multiplikation;
- Erkennen des m-ten signifikanten Bits der zweiten digitalen Daten im Fall der Multiplikation, oder des geringstsignifikanten fikanten Bits der zweiten digitalen Daten im Fall der Division;
- Ausgeben der verschobenen zweiten digitalen Daten dann, wenn das m-te signifikante Bit der zweiten digitalen Daten "0" ist, im Fall der Multiplikation;
- modulo-2-Addieren der ersten digitalen Daten und der verschobenen zweiten digitalen Daten dann, wenn das m-te signifikante Bit der zweiten digitalen Daten nicht "0" ist, um einen addierten Datenwert zu erzeugen, und den addierten Datenwert im Fall der Multiplikation auszugeben;
- Verschieben der zweiten digitalen Daten um ein Bit zur Seite des geringstsignifikanten Bits, wenn das geringstsignifikante Bit der zweiten digitalen Daten "0" ist, und Ausgeben der verschobenen zweiten digitalen Daten im Fall der Division;
- modulo-2-Addieren der ersten digitalen Daten und der zweiten digitalen Daten, wenn das geringstsignifikante Bit der zweiten digitalen Daten nicht "0" ist, um einen Additionsdatenwert im Fall der Division zu erzeugen; und
- Verschieben des Additionsdatenwertes um ein Bit zur Seite des geringstsignifikanten Bits und Ausgeben des Additionsdatenwertes im Fall der Division.

2. Verfahren nach Anspruch 1, dadurch gekennzeichnet, daß die Schritte zur Multiplikation oder Division j-mal für zwei Elemente αⁱ und α^{j} statt αⁱ und α wiederholt werden.

3. Schaltung zum Dekodieren fehlerkorrektur-kodierter Daten durch Handhaben einer Multiplikation oder einer Division betreffend beliebige Elemente αⁱ, wobei i eine ganze Zahl ist, und α über ein finites Feld mit 2^{m}, wobei m eine positive ganze Zahl ist, wobei α eine Wurzel eines primitiven Polynoms des finiten Feldes ist und die Elemente die Bits der Fehlerkorrektur-kodierten Daten sind, welche Schaltung folgendes aufweist:
- einen Akkumulator (10) zum Abspeichern zweiter digitaler Daten mit m Bits entsprechend einer Vektorrepräsentation des beliebigen Elementes αⁱ;
- einen Addierer (11) zum Ausführen einer modulo-2-Addition unter Verwendung des Inhaltes des Akkumulators (10) und erster digitaler Daten mit mindestens m + 1 Bits entsprechend einer Vektorrepräsentation des primitiven Polynoms als Operanden; und
- einem Steuerabschnitt (3) zum Steuern der Bit-Verschiebung im Akkumulator (10) und der Operation des Addierers (11) in solcher Weise, daß:
-- der Akkumulator (10) mit den zweiten digitalen Daten von m Bit versehen wird;
-- die zweiten digitalen Daten im Akkumulator (10) um ein Bit zur Seite des höchstsignifikanten Bits im Fall der Multiplikation verschoben werden;
-- das m-te signifikante Bit der zweiten digitalen Daten im Fall der Multiplikation oder das geringstsignifikante Bit der zweiten digitalen Daten im Fall der Division erkannt wird;
-- Ausgeben der verschobenen zwei digitalen Daten aus dem Akkumulator (10), wenn das m-te signifikante Bit "0" ist, im Fall der Multiplikation;
-- Versorgen des Addierers (11) mit den ersten digitalen Daten, wenn das m-te signifikante Bit der zweiten digitalen Daten nicht "0" ist;
-- modulo-2-Addieren der ersten digitalen Daten und der verschobenen zweiten digitalen Daten aus dem Akkumulator (10), wenn das m-te signifikante Bit der zweiten digitalen Daten nicht "0" ist, um einen Additionsdatenwert zu erzeugen, und um den Additionsdatenwert aus dem Addierer (11) im Fall einer Multiplikation auszugeben;
-- Verschieben der zweiten digitalen Daten im Akkumulator (10) um ein Bit zur Seite des geringstsignifikanten Bits, wenn das geringstsignifikante Bit der zweiten Daten "0" ist, und Ausgeben der verschobenen zweiten digitalen Daten aus dem Akkumulator (10) im Fall der Division;
-- Versorgen des Addierers (11) mit den ersten digitalen Daten, wenn das geringstsignifikante Bit der zweiten digitalen Daten nicht "0" ist;
-- modulo-2-Addieren der ersten digitalen Daten und der zweiten digitalen Daten aus dem Akkumulator (10), wenn das geringstsignifikante Bit der zweiten Daten nicht "0" ist, um einen Additionsdatenwert im Fall der Division zu erzeugen;
-- Abspeichern des Additionsdatenwertes aus dem Addierer (11) im Akkumulator (10); und
-- Verschieben des Additionsdatenwertes im Akkumulator (10) ein Bit zur Seite des geringstsignifikanten Bits, und Ausgeben des Additionsdatenwertes aus dem Akkumulator (10) im Fall der Division.

## Revendications

1. Procédé pour décoder des données codées de correction d'erreur en réalisant une multiplication ou une division en relation avec des éléments arbitraires αⁱ, i étant un entier et α courant sur un domaine fini de 2^{m}, m étant un entier positif, où α est une racine d'un polynôme primitif du domaine fini et lesdits éléments sont les bits desdites données codées de correction d'erreur, le procédé comprenant les étapes de :
fourniture de premières données numériques d'au moins m+1 bits correspondant à une représentation vectorielle du polynôme primitif ;
fourniture de secondes données numériques de m bits correspondant à une représentation vectorielle de l'élément arbitraire αⁱ ;
décalage des secondes données numériques d'un bit vers le côté de bit de poids le plus fort dans le cas de la multiplication ;
discrimination du m-ième bit significatif des secondes données numériques dans le cas de la multiplication ou du bit de poids le plus faible des secondes données numériques dans le cas de la division ;
émission en sortie des secondes données numériques décalées lorsque le m-ième bit significatif des secondes données numériques vaut "0" dans le cas de la multiplication ;
addition modulo 2 des premières données numériques et des secondes données numériques décalées lorsque le m-ième bit significatif des secondes données numériques ne vaut pas "0" de manière à produire des données additionnées et à émettre en sortie les données additionnées dans le cas de la multiplication ;
décalage des secondes données numériques d'un bit vers le côté de bit de poids le plus faible lorsque le bit de poids le plus faible des secondes données numériques vaut "0" et émission en sortie des secondes données numériques décalées dans le cas de la division ;
addition modulo des premières données numériques et des secondes données numériques lorsque le bit de poids le plus faible des secondes données numériques ne vaut pas "0" afin de produire des données additionnées dans le cas de la division ; et
décalage des données additionnées d'un bit vers le côté de bit de poids le plus faible et émission en sortie des données additionnées dans le cas de la division.

2. Procédé selon la revendication 1, caractérisé en ce que lesdites étapes sont répétées j fois pour la multiplication ou pour la division en relation avec deux éléments αⁱ et α^{j} au lieu de αⁱ et de α.

3. Circuit pour décoder des données codées de correction d'erreur en effectuant une multiplication ou une division en relation avec des éléments arbitraires αⁱ, i étant un entier et α courant sur un domaine fini 2^{m}, m étant un entier positif, où α est une racine d'un polynôme primitif du domaine fini et lesdits éléments sont les bits desdites données codées de correction d'erreur, ledit circuit comprenant :
un accumulateur (10) pour stocker des secondes données numériques à m bits correspondant à une représentation vectorielle de l'élément arbitraire αⁱ ;
un additionneur (11) pour réaliser une addition modulo 2 en utilisant les contenus dudit accumulateur (10) et de premières données numériques d'au moins m+1 bits correspondant à une représentation vectorielle du polynôme primitif en tant qu'opérandes ; et
une section de commande (3) pour commander le décalage binaire dans ledit accumulateur (10) et le fonctionnement dudit additionneur (11) de façon à :
appliquer audit accumulateur (10) les secondes données numériques à m bits ;
décaler les secondes données numériques dans ledit accumulateur (10) d'un bit vers le côté de bit de poids le plus fort dans le cas de la multiplication ;
discriminer le m-ième bit significatif des secondes données numériques dans le cas de la multiplication ou le bit de poids le plus faible des secondes données numériques dans le cas de la division ;
émettre en sortie des secondes données numériques décalées depuis ledit accumulateur (10) lorsque le m-ième bit significatif vaut "0" dans le cas de la multiplication ;
appliquer audit additionneur (11) des premières données numériques lorsque le m-ième bit significatif des secondes données numériques ne vaut pas "0" ;
additionner modulo 2 les premières données numériques et les secondes données numériques décalées en provenance dudit accumulateur (10) lorsque le m-ième bit significatif des secondes données numériques ne vaut pas "0" de manière à produire des données additionnées et à émettre en sortie les données additionnées depuis ledit additionneur (11) dans le cas de la multiplication ;
décalee les secondes données numériques dans ledit accumulateur (10) d'un bit vers le côté de bit de poids le plus faible lorsque le bit de poids le plus faible des secondes données vaut "0" et émettre en sortie les secondes données numériques décalées en provenance dudit accumulateur (10) dans le cas de la division ;
appliquer audit additionneur (11) les premières données numériques lorsque le bit de poids le plus faible des secondes données numériques ne vaut pas "0" ;
additionner modulo 2 les première données numériques et les secondes données numériques en provenance dudit accumulateur (10) lorsque le bit de poids le plus faible des secondes données numériques ne vaut pas "0" de manière à produire des données additionnées dans le cas de la division ;
stocker les données additionnées en provenance dudit additionneur (11) dans ledit accumulateur (10) ; et
décaler les données additionnées dans ledit accumulateur (10) d'un bit vers le côté de bit de poids le plus faible et émettre en sortie les données additionnées en provenance dudit accumulateur (10) dans le cas de la division.
